Europäisches Patentamt

European Patent Office

Office européen des brevets

(11) Publication number: **0 485 092 A2**

# EUROPEAN PATENT APPLICATION

(21) Application number: **91309919.8**

(22) Date of filing: **28.10.91**

(51) Int. Cl.⁵: **G03C 7/12, G03F 7/40**

(30) Priority: **07.11.90 JP 299987/90**

(43) Date of publication of application:
**13.05.92 Bulletin 92/20**

(84) Designated Contracting States:
**DE FR GB**

(71) Applicant: **International Business Machines Corporation
Old Orchard Road
Armonk, N.Y. 10504(US)**

(72) Inventor: **Fukunaga, Tetsuya
Tauni Higashirinkan 201, 6-21-27
Kamitsuruma
Sagamihara-shi, Kanagawa-ken(JP)**
Inventor: **Ueki, Toshihiro
Cosumo Machida 208, 3-24-9 Nakamachi
Machida-shi, Tokyo-to(JP)**

(74) Representative: **Killgren, Neil Arthur
IBM United Kingdom Limited Intellectual
Property Department Hursley Park
Winchester Hampshire SO21 2JN(GB)**

(54) **Method for fabricating colour filter.**

(57) A method for fabricating colour filters on a glass substrate is provided in which a layer of insulating material is formed in a pattern on a transparent conductive layer applied to the substrate, a photo resist layer is formed on said pattern, an area of the photo-resist layer wider than an opening in the pattern is exposed and removed and a colour filter is formed in said opening by an electrodeposition.

FIG. 1

This invention relates to a method for fabricating colour filters and more particularly, to a method for fabricating colour filters used in a colour liquid crystal display device, an image scanner, a computer display, a video monitor, TV, or the like.

A colour liquid crystal display usually uses micro-dot colour filters for repeatedly forming coloured pixels in a plurality of colours in sequence at positions and in size corresponding to their display pixels and various techniques for fabricating the colour filters have been proposed. A dyed colour filter formed by dyeing natural protein such as gelatin, glue, casein, etc. or macromolecule has received a practical application to a small-sized portable TV. However, the dyed colour filter involves many problems to be solved that it needs many processes in its manufacturing and is not waterproof, light proof, and heat proof, and it is difficult to control evenly the characteristic of dyeing and fixing for a large screen and to maintain the unevenness of colour or the thickness of a layer. Further, considering gray scale display on an active matrix-type liquid crystal display, it is necessary to make the resistance of an ITO (Indium Tin Oxide), which is formed on the colour filter, low to avoid a problem such as cross talk, etc. To make the resistance of ITO low, in addition to heating, spattering is needed, but there is also a problem that the low-resistance ITO cannot be obtained due to low heat resistance of the dyed colour filter. With respect to a colour filter fabricated using the printing techniques of dry offset printing and intaglio printing it is difficult to satisfy filtering due to an ink of high viscosity, defects are apt to occur due to dust or foreign matter, in addition, a binder in the ink or a gelation part of a vehicle, low positional precision, so that the width of a line of low precision make an opening rate small, and the lack of smoothness on the surface comes into question. Therefore, the above colour filtering is restricted in its usage and it is difficult to use colour display filtering for a colour liquid crystal display with a large screen, of high precision, and capable of displaying gray scale.

A dispersed colour filtering has been proposed which fabricates the colour filter by dispersing pigment or dye in an acrylic resin or a polyimide resin and then patterning them using a photo-lithography technique. However, the above filtering has the problem that the cost of materials is increased.

An electrode position process has been also proposed which fabricates the colour filter by previously forming transparent electrodes in a predetermined pattern and applying voltage to macromolecules containing dye or pigment resolved or dispersed in solvent, in an ionized chamber. The above electrodeposition process needs in addition to the transparent electrodes for display, transparent electrodes for fabricating the colour filter. For the reason why the electrodes must be insulated for each colour, the electrodeposition has the problems that an etching process is necessary, yield is decreased due to conductive detects caused by a short, and it is difficult to apply the electrodeposition to other than a stripe array formed by drawing the transparent electrode around.

Japanese Published Unexamined Patent Applications (PUPA) 61-203403, PUPA 61-272720, and PUPA 61-279803 disclose a method in which the positive photosensitive material is applied to a glass substrate on which a transparent electrode has been formed, a predetermined portion on which a colour filter is to be formed is exposed to the light, and developed to expose the surface of the electrode, and then the colour filter is formed on the exposed electrode surface by an electrodeposition.

Also, PUPA 63-210901 discloses a method in which the positive photosensitive material is applied to a glass substrate on which a transparent electrode has been formed, a predetermined portion on which a colour filter is to be formed is exposed to the light and developed to expose the surface of the electrode, the colour filter is formed on the exposed surface of the electrode by the electrodeposition, the entire positive photosensitive material is exposed to remove the positive photosensitive resin material, and then an exposed transparent conductive layer is removed by etching. Also, PUPA 63-249107 discloses a combination of a method for forming a black matrix by photo etching and a method for forming a resist pattern with a window by photo etching on a transparent conductive layer formed on a glass substrate and fabricating a colour filter by a macromolecule electrodeposition.

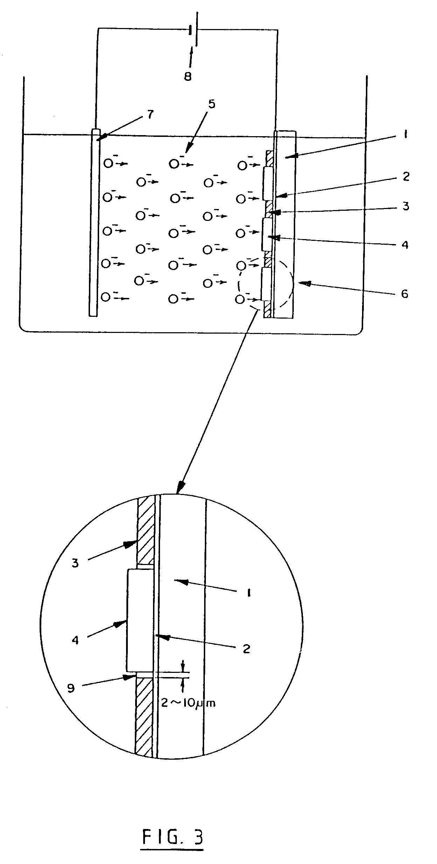

In the following, a prior art principle of fabricating a colour filter by an electrodeposition is described by reference to FIG.3. Firstly, on the entire surface of a glass substrate 1, a transparent conductive layer 2 consisting of ITO is formed by spattering or vacuum evaporation. Secondly, positive photosensitive material 3 is applied to the entire surface of the transparent conductive layer by a spin coat method or a screen printing method. Through a predetermined photo mask, portions, portions selected to form colour filters are exposed to the light and the positive photosensitive material is removed during developing process to expose the transparent conductive layer. The glass substrate thus obtained is dipped into an electrodeposition chamber 6 and connected, through a voltage source, to opposite electrodes 7. In an electrodeposition process, the voltage of DC 50V to DC 80V is applied, ionized coloured particles 5 adhere to the exposed transparent conductive layer, and thus the colour filter is fabricated. At the time of application of voltage, if methods disclosed in Japanese PUPAs 61-203403, 61-272720, 61-279803, 63-210901, and 63-249107 are used, the positive photosensitive materials very close to the colour filter are polymerized under the electrochemical reaction to increase molecular weight. Polymerization occurs in portions of an outline width of 2 to 10 m where the colour filter is fabricated. The remaining positive photosensitive material, if any, must be removed after predetermined three-colour colour filters have been fabricated, however, this has the problem that it is difficult to detach or remove polymerized positive photoresists very close to the colour filters without damaging the fabricated colour filters. The polymerized positive photoresists cannot be fully removed even by a method which exposes the entire surface to the light disclosed in Japanese PUPA 63-210901 or even by the use of various solvents (for example, a diethylene glycol, a monobutyl ether, or an acetic acid butyltesters) because the above solvents dissolve not only the positive photosensitive material, but also the electrodeposited colour filter. Thus the polymerized positive photosensitive materials with increased molecular weight, which adhere to the electrodeposited colour filter cannot be dissolved selectively by any solvent. According to an experiment by the inventor, it is clear that degree of polymerization of the positive photosensitive material during the electrodeposition and portions in which the polymerization occurs depend upon the conditions of the electrodeposition such as voltage, time, temperature, PH, etc. However, the experiment had the problem that under the conditions of the electrodeposition which can fabricate the colour filters that satisfy a requested characteristic of spectral transmission, the polymerization of positive photosensitive material cannot be fully avoided.

If electrodeposited colour filters are fabricated, in accordance with a method disclosed in Japanese PUPAs 61-203403, 61-272720, and 61-279803, it is assumed that the formation of a black matrix by self alignment during electrodeposition is basically possible after three-colour colour filters are fabricated. However, as described above, the polymerized positive photosensitive material cannot be fully removed and a black matrix is not basically formed, due to insulation of the remaining polymerized positive photosensitive material, in their portions. This causes a problem that the light leaks out from the outline portions of the filters and display is presented in a significantly inferior colour. Further, according to the above methods, the opening of the black matrix is determined based on positioning precision at the time of the exposure of the positive photosensitive material to the light and formed sequentially by exposing the positive photosensitive material three times to the light, and, as a result, errors are accumulated. Therefore, this involves a problem that on comparing usual formation by exposing once to the light, a larger margin is needed and thus the width of the opening must be decreased by the margin.

According to the present invention, there is provided a method for fabricating colour filters on a substrate comprising the steps of:

(a) forming a transparent conductive layer on said glass substrate;

(b) forming an insulating light shielding layer in a pattern on said transparent conductive layer;

(c) forming a photoresist layer on said pattern;

(d) exposing and removing an area of said photoresist layer; wider than an opening of said pattern and

(e) forming a first colour filter in said opening of the pattern by an electrodeposition method.

A method for fabricating colour filters according to the present invention forms a black matrix of an insulating material on a glass substrate on which a transparent electrode has been formed, applies a positive photosensitive resin to the black matrix, exposures the positive photosensitive resin, through a photo mask having portions through which the light transmits, wider than the opening of the black matrix, removes an exposed positive resist during process of development, and fabricates a colour filter in a first colour, and then exposures and develops the remaining positive resist at a position where adjacent colour filter in a second colour is to be formed in the same manner and fabricates a colour filter in a second colour by electrodeposition, and then fabricate a colour filter in a third colour in the same manner as the above.

The present invention enables the above problems to be solved by, providing a method for fabricating high-quality and inexpensive colour filters, regardless of whether they are of an active matrix or a simple matrix type.

In the present invention, an insulating black matrix is previously formed on a transparent conductive layer and the black matrix is used as a mask close to a portion at which a predetermined colour filter is formed by electrodeposition.

An embodiment of the invention will now be described with reference to the accompanying drawing, wherein;

FIG. 1(a) to (o) are illustrations showing processes for fabricating colour filters of a embodiment according to the present invention.

FIG.2 shows the relationship between the opening of a black matrix shown in FIG.1 and the aperture of a photo mask through which the light passes.

FIG.3 is a view showing a principle of fabricating colour filters by electrodeposition.

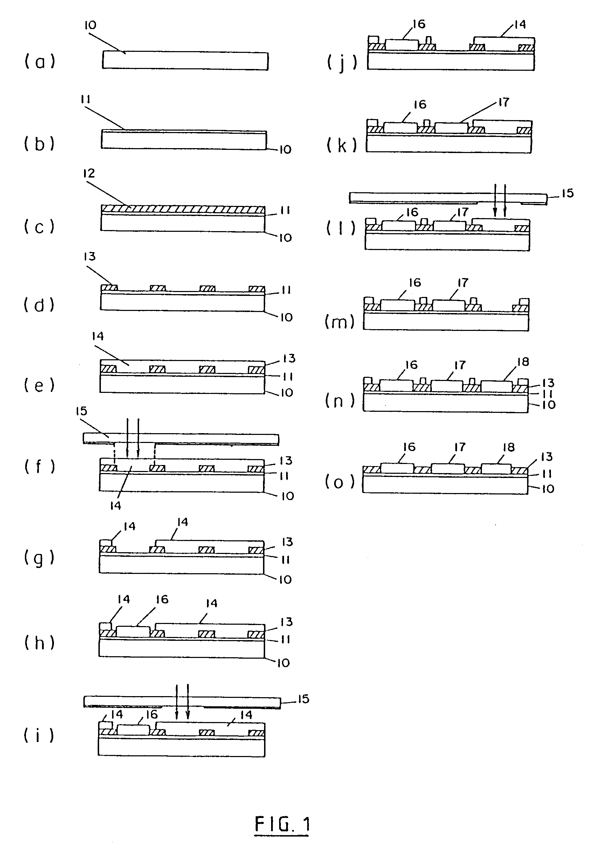

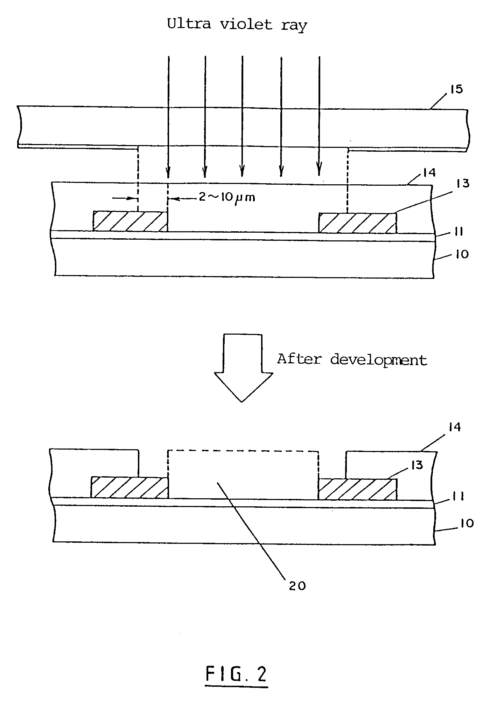

FIG.1 shows manufacturing processes of colour filters of an embodiment of the present invention. FIG.2 is an illustration in which a part of FIG.1 is enlarged.

In the following, the embodiment of the present invention is described in detail by reference to FIG.1 and FIG.2.

First, on the entire surface of a glass substrate 10 (Refer to FIG.1(a)), a transparent conductive layer 11 is formed, as shown in FIG.1(b), the negative photosensitive material 12 containing dispersed insulating material of low transmission factor of the light (for example, black pigment) is spin-coated (Refer to FIG.1(c)), exposed through a predetermined photo mask and developed to form a black matrix 13, as shown in FIG.1(d). Then as shown in FIG.1(e), the positive photosensitive material 14 is applied to the black matrix 13, the positive photosensitive material 14 is exposed, through the aperture of a photo mask 15, through which the light transmits, wider than the opening of the formed black matrix, to the light (Refer to FIG.1(f)), and then developed to remove the positive photosensitive material 14 and to expose the transparent conductive material 11 (Refer to FIG.1(g)). The width of the opening of the black matrix 13 is smaller than that of the aperture of the photo mask 15, through which the light passes, by a distance of 2-10 m, as shown in FIG.2, since a size of the area of the positive photosensitive material which was polymerized during the electrodeposition was 2-10 m. After the process shown in FIG.1(g), a red colour filter 16 of a first colour is fabricated, as shown in FIG.1(h). Secondly, to fabricate a colour filter of a second colour, the positive photosensitive material is exposed through the photo mask 15 in the same manner as the process shown in FIG.1(f) (Refer to FIG.1(i)) and then the positive photosensitive material 14 is removed by development to expose the transparent conductive layer 11 (Refer to FIG. 1(j)) and finally, in a process shown in FIG.1(k), a green colour filter 17 of a second colour is formed. Finally, in a process shown in FIG.1(l) the positive photosensitive material 14 is exposed through the photo mask 15 in the same manner as the process shown in FIG.1(f), and then removed by development to expose the transparent conductive layer 11 (Refer to FIG.1(m)) and finally, in a process shown in FIG.1(n), a blue colour filter 18 of a third colour is formed.

Through the above manufacturing process, the colour filters 16, 17, and 18 of three primary colours, red, green, and blue, can be fabricated, respectively (Refer to FIG.1(o)).

Since the positive photosensitive material 14 remaining on the black matrix 13 has not been polymerized, it can be easily removed, after its entire surface has been finally exposed, through a development process. Further, if the photo mask used for removing the positive photosensitive material 14 is designed so that the aperture of the photo mask through which the light transmits becomes larger than the area of one pixel, exposed portions overlap through exposing processes in three times, the positive photosensitive material 14 does not remain on the glass substrate at the completion of the third development process, and thus a process for peeling or removing the remaining material is not needed.

There has been described a method for fabricating colour filters according to the present invention, in which an insulating black matrix is previously formed on a transparent conductive layer and the black matrix is used as a mask for the neighbourhood of a portion in which an electro deposited colour filter is formed. Therefore, the method enables display to be high contrast in a state where the light does not leak out and, in addition, enables the fabricates of colour filters with a very high positional accuracy and with, optional colour arrangements.

Further, the method has an advantage that the application of a photoresist which has a significant effect on the yield of the colour filters is only needed twice, and thus remarkable improvements can be made on the yield and cost.

**Claims**

1. A method for fabricating colour filters on a substrate comprising the steps of:

   (a) forming a transparent conductive layer on said glass substrate;

   (b) forming an insulating light shielding layer in a pattern on said transparent conductive layer;

   (c) forming a photoresist layer on said pattern;

   (d) exposing and removing an area of said photoresist layer; wider than an opening of said pattern and

   (e) forming a first colour filter in said opening of the pattern by an electrodeposition method.

2. A method for fabricating colour filters as claimed in claim 1 wherein after said first colour filter is formed, said step (d) is performed without removal of the remaining part of said photoresist and a second colour filter is formed, by said electrodeposition method, at a predetermined position adjacent to said first colour filter.

3. A method for fabricating colour filters as claimed in claim 1 wherein after said second colour filter is formed, said step (d) is performed without removal of said remaining photoresist layer and a third colour filter is formed, by said electrodeposition, at a predetermined position adjacent to said second colour filter.

4. A method for fabricating colour filters as claimed in any preceding claim wherein said transparent conductive layer is Indium Tin Oxide (ITO).

5. A method for fabricating colour filters as claimed in any preceding claim wherein said light shielding layer is a black matrix.

6. A method for fabricating colour filters as claimed in any preceding claim wherein said photoresist is the positive photosensitive material.

7. A method for fabricating colour filters as claimed in any preceding claim wherein said first colour filter is a red colour filter.

8. A method for fabricating colour filters as claimed in claim 2 or any of claims 4 to 6 as dependent as claim 2 wherein said second colour filter is a green colour filter.

9. A method for fabricating colour filters as claimed in claim 3 or any of claims 4 to 6 as dependant on claim 3 wherein said third colour filter is a blue colour filter.

FIG. 1

Ultra violet ray

15

14
13
11
10

$2\sim10\mu m$

After development

14
13
11
10

20

F I G. 2

FIG. 3